# EUROPEAN PATENT APPLICATION

(11) **EP 4 760 842 A1**
(43) Date of publication of application: **17.06.2026**
(21) Application number: 25854621.7
(22) Date of filing: 08.08.2025
(51) Int. Cl.: H01M 10/04, H01M 10/44, H01M 4/04, G01R 31/3835, G01R 31/385, G01R 31/36, H01M 10/613

(54) **SYSTEM FOR PRESSURIZING AND COOLING BATTERY CELL AND OPERATING METHOD THEREOF**

(30) Priority: 13.08.2024 KR 20240108099
(71) Applicant: LG Energy Solution, Ltd., Seoul 07335 (KR)
(72) Inventor: JEON, Sang Chul, Daejeon 34122 (KR); LEE, Ho Jung, Daejeon 34122 (KR); SIM, Jae Yeong, Daejeon 34122 (KR); BAEK, Ju Hwan, Daejeon 34122 (KR)
(74) Representative: Goddar, Heinz J.
(86) International application number: PCT/KR2025/012014
(87) International publication number: WO 2026/038814

(57) **Abstract**

Disclosed are a battery cell pressing and cooling system capable of reducing the process time required when cooling and pressing a pouch battery cell during an activation process of the pouch battery cell and measuring the voltage of the battery cell at the same time, thereby dramatically shortening the process time, and a method of operating the same.

## Description

### [Technical Field]

This application claims the benefit of priority to Korean Patent Application No. 2024-0108099 filed on August 13, 2024, the disclosure of which is incorporated herein by reference in its entirety.

The present invention relates to a battery cell pressing and cooling system and a method of operating the same, and more particularly to a battery cell pressing and cooling system capable of reducing the process time required when cooling and pressing a pouch battery cell during an activation process of the pouch battery cell and measuring the voltage of the battery cell at the same time, thereby dramatically shortening the process time, and a method of operating the same.

### [Background Art]

With recent development of alternative energies due to air pollution and energy depletion caused as the result of use of fossil fuels, demand for secondary batteries capable of storing electrical energy that is produced has increased.

Required capacities of secondary batteries used as energy sources of various kinds of electronic devices inevitably used in modern society have been increased due to an increase in usage of mobile devices, increasing complexity of the mobile devices, and development of electric vehicles. In order to satisfy demand of users, a plurality of battery cells is disposed in a small-sized device, whereas a battery module including a plurality of battery cells electrically connected to each other or a battery pack including a plurality of battery modules is used in a vehicle, etc.

Recently, a pouch-shaped battery having a structure in which a stacked type electrode assembly or a stacked and folded type electrode assembly is mounted in a pouch-shaped battery case has been increasingly used for reasons of low manufacturing cost, light weight, easy deformation, etc.

Meanwhile, in a pouch battery cell manufacturing process, an electrode assembly is received in a pouch case, an electrolyte is injected into the pouch case, and an edge of the pouch case is heated and pressed to form a sealed portion. At this time, an electrode lead having one side connected to an electrode tab of the electrode assembly and the other side protruding outwardly of the pouch case may be located in the sealed portion, and an insulating film may be located between the sealed portion and the electrode lead.

Such a pouch-shaped battery cell undergoes an activation process after the electrolyte is injected into the pouch-shaped case having the electrode assembly received therein. The activation process is crucial in imparting electrical characteristics to the battery cell and forming an electrode SEI layer. During the activation process, gas is generated in the battery cell due to charging and discharging of the battery cell, whereby a swelling phenomenon in which the battery cell swells occurs, and in the part where the gas is generated, the solid electrolyte interphase (SEI) layer may be unevenly formed.

Therefore, during the activation process, in order to prevent gas trapping in the battery cell, to uniformly form the SEI layer, and to improve electrolyte impregnation by pressing the battery cell swollen by swelling due to charging and discharging or cooling the heated battery cell, the operations of pressing and cooling both side surfaces of the pouch battery cell are performed.

However, pressing and cooling processes of a conventional activation process have long process time, which negatively impacts the production efficiency of battery cells, such as PPM (parts per minute), which is the number of battery cells produced per minute, or tack time, which is the process time relative to the total logistics time, and the process area required.

Korean Patent Application Publication No. 2022-0153289 discloses a conveyor system for battery activation processes, wherein the conveyor system minimizes vibration of a cell transfer tray when horizontally moving the cell transfer tray, changing the direction of the cell transfer tray (diverting the cell transfer tray), or rotating the cell transfer tray, and prevents collision of the cell transfer tray with a preceding cell transfer tray.

Korean Patent Application Publication No. 2004-0026543 discloses a battery manufacturing system including a tray introduction portion, a tray transfer portion configured to transfer an empty tray from the tray introduction portion to another place, a battery introduction portion configured to introduce a battery from the tray introduction portion to a manufacturing process, a gas discharging and sealing portion configured to discharge gas from the battery transferred from the tray introduction portion by perforating the battery and to seal the perforated battery, a buffer region in which the battery is temporarily held after gas discharge and sealing, a heating sealing portion configured to reheat and seal the edge of the battery transferred from the buffer region, and a cooling portion configured to cool the heated and sealed part of the battery.

However, the above prior art documents do not disclose a battery cell pressing and cooling system according to the present invention that presses and cools a plurality of battery cells considering the transfer flow of a tray including the plurality of battery cells and simultaneously measures the voltage of the battery cells while the process is performed, and a method of operating the same.

Therefore, there is a need for a battery cell pressing and cooling system capable of reducing the process time required when cooling and pressing a pouch battery cell during an activation process of the pouch battery cell and measuring the voltage of the battery cell at the same time, thereby dramatically shortening the process time, and a method of operating the same.

### [Disclosure]

### [Technical Problem]

The present invention has been made in view of the above problems, and it is an object of the present invention to provide a battery cell pressing and cooling system capable of reducing the process time required when cooling and pressing a pouch battery cell during an activation process of the pouch battery cell and measuring the voltage of the battery cell at the same time, thereby dramatically shortening the process time, and a method of operating the same.

### [Technical Solution]

A battery cell pressing and cooling system according to the present invention to accomplish the above object includes a tray (100) configured to receive a plurality of battery cells (C), a conveyor (200) configured to transfer the tray, a pick and place (P&P) unit (300) on the conveyor, at least one gripper unit (400) configured to move the battery cells, and at least one cooling unit (500) configured to press and cool the battery cells in the tray, wherein a transfer line of the conveyor has a " 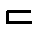 " shape, and the cooling unit is in a " 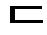 "-shaped inner space of the transfer line.

In addition, the conveyor may include a first conveyor (210) configured to move the tray in a horizontal (x-axis) direction, a second conveyor (220) connected orthogonally to the first conveyor, the second conveyor being configured to move the tray in a vertical (y-axis) direction, and a third conveyor (230) connected orthogonally to the second conveyor, the third conveyor being configured to move the tray in the horizontal (x-axis) direction, a first conversion unit (211) configured to convert a direction of the tray such that the tray moves to the second conveyor on a first side of the first conveyor in contact with the second conveyor, and a second conversion unit configured to convert the direction of the tray such that the tray moves to the third conveyor on a first side of the third conveyor in contact with the second conveyor.

In addition, the P&P unit may include a P&P sensor (310) configured to sense introduction and discharge of the tray, a base plate (320) on which the tray is located, a P&P position adjustment unit (330) configured to adjust x-axis and y-axis positions of the tray, and a P&P discharge unit (340) configured to discharge the tray, and the P&P position adjustment unit may be configured to finely adjust the position of the tray such that the gripper unit grips the battery cells.

In addition, the gripper unit may include a first support body (410) configured to move in an up-and-down (z-axis) direction, a second support body (420) configured to move in the horizontal (x-axis) direction and the vertical (y-axis) direction, and a gripper (430) configured to simultaneously grip the plurality of the battery cells in the tray on the base plate, and the gripper may include a plurality of " 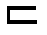 "-shaped gripping portions (431) configured to be in contact with both side surfaces of the respective battery cells, a pressing portion (432) configured to transmit a driving force to adjust the width of each of the gripping portions such that the gripping portions can grip the battery cells, and a pressure sensor (433) on the inside of the gripping portion in contact with both side surfaces of each of the battery cells.

In addition, the cooling unit may include a plurality of pressing bodies (510) facing rectangular planes of the plurality of battery cells, the pressing bodies being configured to press the battery cells, and a plurality of battery cell support portions (520) configured to move together with the battery cells in a pressing direction when the pressing bodies press the battery cells, the battery cell support portion (520) may include a base frame (521) under the pressing body and a battery cell support frame (522) configured to move the battery cell upward and downward from the base frame in the up-and-down (z-axis) direction, and a refrigerant flow path (not shown) may be in the pressing body.

In addition, an electrode contact unit (530) configured to measure the voltage of the battery cell when the pressing body presses and cools the battery cell may be at each of both ends of the pressing body in a longitudinal direction.

In addition, the electrode contact unit fixedly attached to one surface of the pressing body may include a "^"-shaped lead insertion portion (531) configured to allow a lead of the battery cell to be inserted thereinto, a voltage sensing terminal inside the lead insertion portion in contact with the lead, and a driving portion configured to move the lead insertion portion in a direction in which the lead is located or in an opposite direction thereto, and when the battery cell is at a position at which the battery cell is pressed by the pressing body, the driving portion may be configured to move the lead insertion portion in the direction toward the lead such that the lead is in contact with the voltage sensing terminal.

In addition, the battery cell pressing and cooling system may further include a chiller unit (600) configured to supply a refrigerant to the pressing body, wherein the chiller unit may include a cooling tank (610) configured to receive the refrigerant, the cooling tank may include a return port through which the refrigerant, after performing heat exchange with the pressing body of the cooling unit, is supplied via a return line (620) and a supply port through which the refrigerant cooled in the cooling tank is discharged via a supply line (630), a refrigerant line (611) configured to perform heat exchange with the refrigerant may be in the cooling tank, and the chiller unit may include a refrigerator (640) configured to supply cooling energy to the cooling tank via the refrigerant line.

In addition, the P&P unit may include a first P&P unit (300a) at the first conveyor and a second P&P unit (300b) at the third conveyor, and the first P&P unit and the second P&P unit may alternately grip the plurality of battery cells in the plurality of trays that are sequentially introduced.

In addition, the gripper unit may be configured to grip the plurality of the battery cells and position the gripped battery cells between the plurality of pressing bodies, and upon completion of pressing and cooling of the battery cells, the gripper unit may be configured to grip the battery cells again and move the gripped battery cells to the tray.

In addition, the cooling unit may include a first cooling unit (500a) configured to press and cool the battery cells in conjunction with the first P&P unit and a second cooling unit (500b) configured to press and cool the battery cells in conjunction with the second P&P unit.

In addition, the gripper unit may include a first gripper unit (400a) configured to grip the battery cells in conjunction with the first P&P unit and a second gripper unit (400b) configured to grip the battery cells in conjunction with the second P&P unit.

In addition, a method of controlling a battery cell pressing and cooling system according to the present invention includes a first step of sequentially introducing a plurality of trays, each of the plurality of trays being configured to receive a plurality of battery cells, to a conveyor, a second step of moving the tray to a predetermined position through a P&P unit on the conveyor, a third step of moving the plurality of battery cells from the tray to a cooling unit through a gripper unit, a fourth step of simultaneously pressing and cooling the plurality of battery cells through the cooling unit, a fifth step of moving the plurality of battery cells, after completion of the pressing and the cooling, to the tray through the gripper unit, and a sixth step of sequentially discharging the plurality of trays, each having the plurality of battery cells received therein, from the conveyor, wherein a transfer line of the conveyor has a " 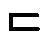 " shape, the cooling unit is in a " 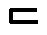 "-shaped inner space of the transfer line, and each of the P&P unit, the gripper unit, and the cooling unit is one or more P&P unit, gripper unit or cooling unit, respectively.

The present invention may provide various combinations of the above solving means.

### [Advantageous Effects]

As is apparent from the above description, a battery cell pressing and cooling system according to the present invention has the effect of dramatically reducing the time required for an activation process of a plurality of battery cells, thereby improving PPM (parts per minute).

In addition, the battery cell pressing and cooling system according to the present invention has the effect that a transfer line of a conveyor configured to transfer a tray is formed in a " 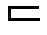 " shape to improve logistics layout, thereby reducing the process time and process area required for a battery cell to be pressed and cooled.

In addition, the battery cell pressing and cooling system according to the present invention has the effect that the battery cell is uniformly pressed between the pressing bodies while being simultaneously cooled, whereby it is possible to manufacture battery cells with consistent quality during the activation processes, etc.

In addition, the battery cell pressing and cooling system according to the present invention has the effect that the voltage of the battery cell is measured simultaneously with pressing and cooling of the battery cell, whereby it is possible to monitor the state of the battery cell during the process.

In addition, the battery cell pressing and cooling system according to the present invention has the effect that two or more P&P units, gripper units, and cooling units are coupled to the " 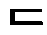 "-shaped conveyor, whereby it is possible to reduce the time required for pressing and cooling the battery cell.

### [Description of Drawings]

FIG. 1 is a plan view of a battery cell pressing and cooling system according to an embodiment of the present invention.
FIG. 2 is a sectional view of a gripper unit of the battery cell pressing and cooling system according to the embodiment of the present invention.
FIG. 3 is a perspective view showing that the gripper unit of the battery cell pressing and cooling system according to the embodiment of the present invention grips a plurality of battery cells.
FIG. 4 is a perspective view of a cooling unit of the battery cell pressing and cooling system according to the embodiment of the present invention.
FIG. 5 is a plan view of an electrode contact unit of the cooling unit of the battery cell pressing and cooling system according to the embodiment of the present invention.
FIG. 6 is a perspective view showing a joint between an electrode lead and the electrode contact unit of the cooling unit of the battery cell pressing and cooling system according to the embodiment of the present invention.
FIG. 7 is a configuration view of a chiller unit of the battery cell pressing and cooling system according to the embodiment of the present invention.

### [Best Mode]

Now, preferred embodiments of the present invention will be described in detail with reference to the accompanying drawings such that the preferred embodiments of the present invention can be easily implemented by a person having ordinary skill in the art to which the present invention pertains. In describing the principle of operation of the preferred embodiments of the present invention in detail, however, a detailed description of known functions and configurations incorporated herein will be omitted when the same may obscure the subject matter of the present invention.

In addition, the same reference numbers will be used throughout the drawings to refer to parts that perform similar functions or operations. In the case in which one part is said to be connected to another part throughout the specification, not only may the one part be directly connected to the other part, but also, the one part may be indirectly connected to the other part via a further part. In addition, that a certain element is included does not mean that other elements are excluded, but means that such elements may be further included unless mentioned otherwise.

Hereinafter, a battery cell pressing and cooling system according to the present invention and a method of controlling the same will be described with reference to the accompanying drawings.

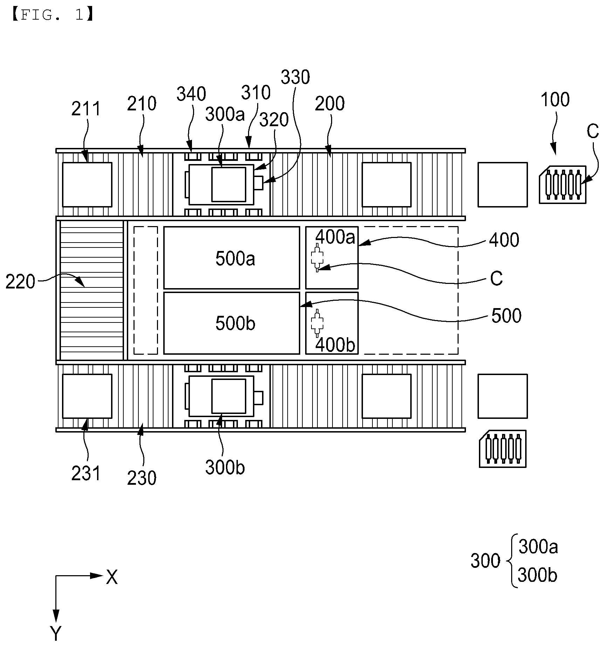

FIG. 1 is a plan view of a battery cell pressing and cooling system according to an embodiment of the present invention.

The battery cell pressing and cooling system may be a battery cell pressing and cooling system including a tray 100 configured to receive a plurality of battery cells C, a conveyor 200 configured to transfer the tray 100, a pick and place (P&P) unit 300 formed on the conveyor 200, at least one gripper unit 400 configured to move the battery cells C, and at least one cooling unit 500 configured to press and cool the battery cells C in the tray 100, wherein a transfer line of the conveyor 200 is formed in a " 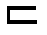 " shape, and the cooling unit 500 is located in a " 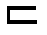 "-shaped inner space of the transfer line.

The battery cell, preferably a pouch-shaped battery cell, includes a gas pocket portion and a battery portion having an electrode assembly received therein.

The tray 100 is formed with an open top configuration, and the plurality of battery cells C is mounted in the tray in the state in which the battery cells are vertically arranged such that the battery portions thereof are in contact with each other.

Typically, a battery activation process for manufacturing battery cells includes various steps, and assembly and other operations are performed while a cell transfer tray is moved. For a conveyor used on a manufacturing line, a free-flow chain system is employed, necessitating a buffer section. Therefore, a stopper operated by an air cylinder with a cushioning function is used.

Furthermore, a directional change section of the conveyor is configured using a roller driving system, and a rotary plate for rotating a cell transfer tray made of a synthetic resin may be disposed.

The conveyor 200 may include a first conveyor 210 configured to move the tray 100 in a horizontal (x-axis) direction, a second conveyor 220 connected orthogonally to the first conveyor 210, the second conveyor being configured to move the tray 100 in a vertical (y-axis) direction, and a third conveyor 230 connected orthogonally to the second conveyor 220, the third conveyor being configured to move the tray 100 in the horizontal (x-axis) direction, wherein a first conversion unit 211 configured to convert the direction of the tray 100 such that the tray moves to the second conveyor 220 may be disposed on a first side of the first conveyor 210 in contact with the second conveyor 220, and a second conversion unit 231 configured to convert the direction of the tray 100 such that the tray moves to the third conveyor 230 may be disposed on a first side of the third conveyor 230 in contact with the second conveyor 220.

In the battery cell pressing and cooling system employing the " 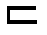 "-shaped conveyor including the first conveyor to the third conveyor, the plurality of conveyors may be variously disposed so as to be connected to each other in the horizontal direction and/or the vertical direction.

The conveyor, preferably a roller conveyor, may be a unit conveyor including a plurality of width-direction rollers disposed such that both ends of roller shafts are supported on conveyor supports installed side by side above a support frame so as to match the width of the battery cell transfer tray, guide rails coupled to upper sides of the conveyor supports, the guide rails being configured to guide the battery cell transfer tray, a power transmission means installed to provide driving force to the adjacent roller shafts of the width-direction rollers, the power transmission means including a pulley and a belt, and a driving motor installed on any one of the roller shafts, the driving motor being configured to provide driving force.

Each of the first conversion unit 211 and the second conversion unit 231 may include at least two belt conveyors installed between width-direction rollers of a direction conversion roller conveyor configured to convert the movement direction of the tray in axial directions of the rollers, a support member on which the belt conveyors are installed, a lifting platform plate connected to a lower side of the support member, and a lifting cylinder installed on the support member, the lifting cylinder being configured to move the lifting platform plate upward and downward.

A conversion unit power transmission mechanism and a conversion unit rotating mechanism configured to convert the direction of the tray may be further included. The conversion unit power transmission mechanism may include a support body, a plurality of shafts, and a power transmission motor, and the conversion unit rotating mechanism may include a support body, a rotating guide rail, and a power transmission motor.

The P&P unit 300 may include a P&P sensor 310 configured to sense introduction and discharge of the tray 100, a base plate 320 on which the tray 100 is located, a P&P position adjustment unit 330 configured to adjust x-axis and y-axis positions of the tray 100, and a P&P discharge unit 340 configured to discharge the tray 100, wherein the P&P position adjustment unit 330 may finely adjust the position of the tray 100 such that the gripper unit 400 can grip the battery cells C.

The P&P unit (pick and place) 300 performs the function of gripping the battery cells C from the tray 100 and transferring the gripped battery cells to the cooling unit 500. The P&P sensor 310 senses the tray 100 entering the P&P unit 300 and transmits sensing information for determining whether to proceed with a battery cell gripping operation in the P&P unit 300 to a controller (not shown).

The P&P sensor 310 selects one of two trays 100 that are sequentially transferred and performs the battery cell gripping operation. The unselected tray undergoes the battery cell gripping operation in the P&P unit 300 formed on the " 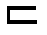 "-shaped third conveyor 230.

The P&P position adjustment unit 330 may perform fine position adjustment to position the selected tray at the correct position of the gripper unit 400 for gripping the battery cells on the base plate 320 where the selected tray is located. The P&P position adjustment unit 330 may include a motor or a hydraulic cylinder configured to move the base plate 320 for multiple position adjustments.

The P&P discharge unit 340 performs the function of discharging the tray 100 toward the first conveyor 210 linked to a rear end of the P&P unit 300 when the battery cell pressed and cooled in the cooling unit 500 is moved back to the tray by the gripper unit 400. The P&P discharge unit 340 may include a motor or a pressing cylinder configured to move the tray 100.

The P&P unit 300 may dispose the selected tray so as not to be located on the first conveyor 210 in order to prevent interference with the movement of individual trays when a plurality of trays 100 is moved. For example, the P&P unit 300 may transfer the selected tray upward and downward in a z-axis direction, or move the selected tray in the y-axis direction or the x-axis direction such that the selected tray deviates from moving lines of trays that are moved.

A controller (not shown) configured to control the battery cell pressing and cooling system may be further included. The controller performs the function of collecting sensing information and driving information from the units constituting the system and controlling pressing and cooling of the battery cells and introduction and discharge of the trays.

The P&P unit may include a first P&P unit 300a formed at the first conveyor and a second P&P unit 300b formed at the third conveyor, wherein the first P&P unit 300a and the second P&P unit 300b may alternately grip the plurality of battery cells in the plurality of trays that are sequentially introduced.

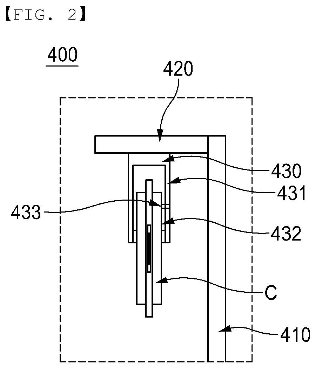

FIG. 2 is a sectional view of the gripper unit of the battery cell pressing and cooling system according to the embodiment of the present invention.

Referring to FIG. 2, the gripper unit 400 includes a first support body 410 configured to move in an up-and-down (z-axis) direction, a second support body 420 configured to move in the horizontal (x-axis) and vertical (y-axis) directions, and a gripper 430 configured to simultaneously grip the plurality of the battery cells in the tray located on the base plate, wherein the gripper 430 includes a plurality of " 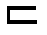 "-shaped gripping portions 431 configured to be in contact with both side surfaces of the respective battery cells, a pressing portion 432 configured to transmit driving force necessary to adjust the width of each of the gripping portions 431 such that the gripping portions can grip the battery cells, and a pressure sensor 433 located on the inside of the gripping portion 431 in contact with both side surfaces of each of the battery cells.

The first support body 410 functions to move the gripper 430, which has been moved to a position for gripping the battery cell C in the tray 100 by horizontal and vertical movement through the second support body 420, in the up-and-down (z-axis) direction. The gripper 430 and the battery cell C may substantially contact each other through driving of the first support body 410. The second support body 420 may include a motor, a guide rail, and a sensor for moving the gripper 430.

The second support body 420 may move the gripper 430 to a position for gripping the battery cell C in the tray 100 in the horizontal (x-axis) direction, preferably the direction perpendicular to movement direction of the tray 100 (y-axis direction) on the first conveyor 210 and third conveyor 230, preferably the movement direction of the tray 100 on the second conveyor 220. The second support body 410 may include a motor, a guide rail, and a sensor for moving the gripper.

The gripper unit 400 may grip the plurality of the battery cells C, may locate the gripped battery cells between the plurality of pressing portions 432, and, upon completion of pressing and cooling of the battery cells C, may grip the battery cells C again, and move the gripped battery cells to the tray 100.

The gripper unit 400 may include a first gripper unit 400a configured to grip the battery cells C in conjunction with the first P&P unit 300 and a second gripper unit 400b configured to grip the battery cells in conjunction with the second P&P unit.

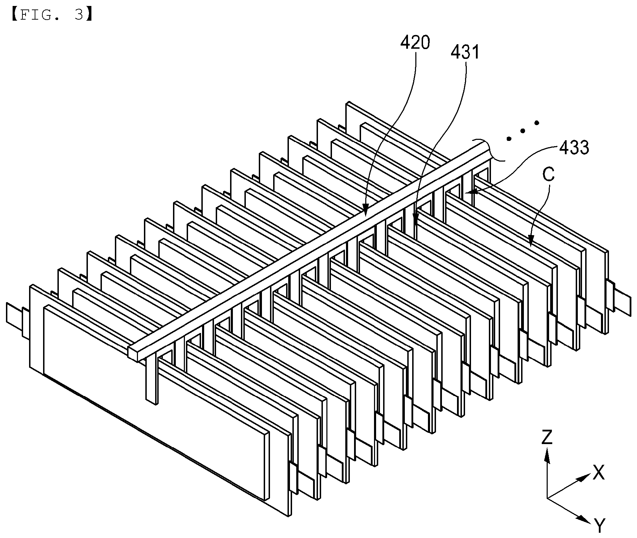

FIG. 3 is a perspective view showing that the gripper unit of the battery cell pressing and cooling system according to the embodiment of the present invention grips the plurality of battery cells.

Referring to FIG. 3 together with FIG. 2, the gripper 430 includes a plurality of gripping portions 431 sequentially formed at regular intervals, wherein, when the gripper is located on z-axis upper surfaces of the plurality of battery cells C aligned on the tray, the width of each of the gripping portions 431 is increased so as to be greater than the thickness of a corresponding one of the battery cells C, and the gripping portions 431 enter between the battery cells C.

Subsequently, the battery cell C is gripped by the gripping portion 431 via the pressing portion 432, and the pressure sensor 433 formed inside the gripping portion 431 monitors whether the gripping portion 431 has gripped the battery cell with a predetermined pressing force.

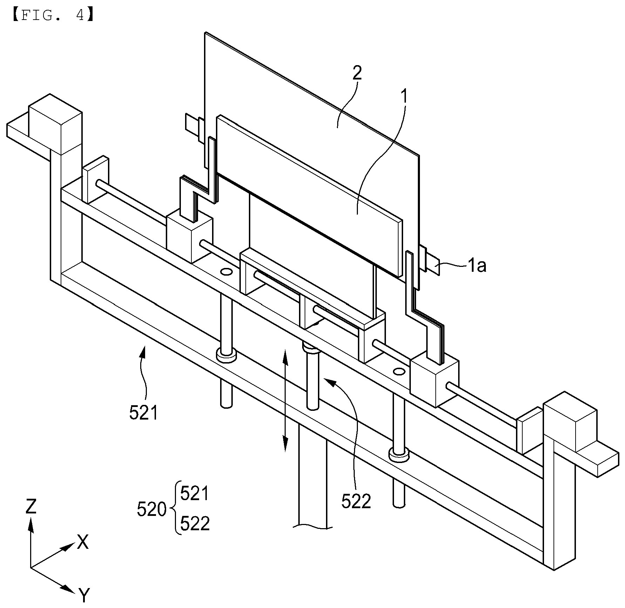

FIG. 4 is a perspective view of the cooling unit of the battery cell pressing and cooling system according to the embodiment of the present invention.

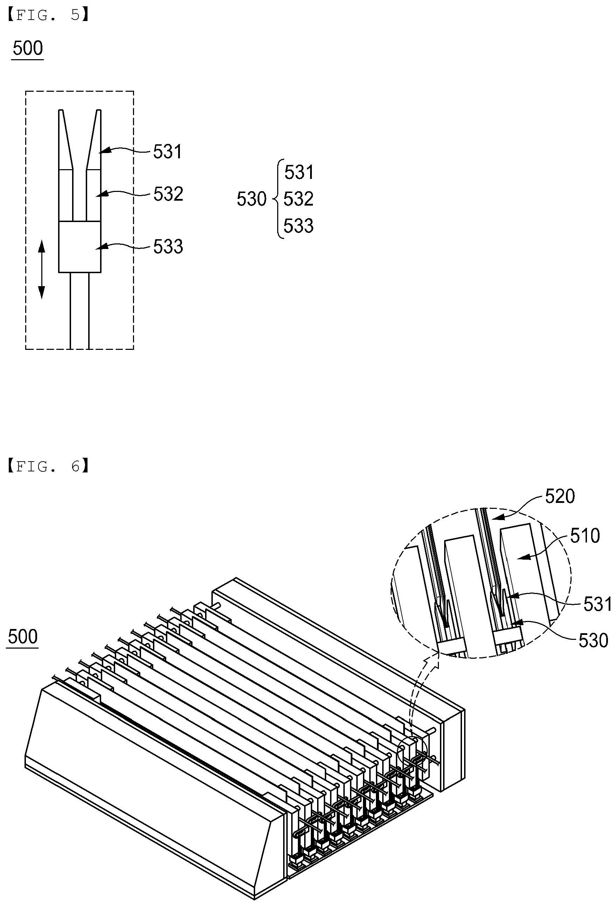

Referring to FIG. 4, the cooling unit 500 may include a plurality of pressing bodies 510 (FIG. 6) disposed so as to face rectangular planes of the plurality of battery cells C, the pressing bodies being configured to press the battery cells C, and a plurality of battery cell support portions 520 configured to move together with the battery cells in a pressing direction when the pressing bodies press the battery cells, wherein the battery cell support portion 520 may include a base frame 521 located under the pressing body 510 and a battery cell support frame 522 configured to move the battery cell upward and downward from the base frame in the up-and-down (z-axis) direction, and a refrigerant flow path (not shown) may be formed in the pressing body 510.

The pressing body 510 may have a rectangular shape. The pressing body 510 is not limited in shape as long as it is possible to uniformly press and cool the battery cell C. The pressing body 510 is rectangular in shape so as to correspond to the rectangular shape of the battery cell C, and the surface of the pressing body 510 facing the battery cell may be flat or rounded so as to correspond to a swelling portion of the battery cell.

A plurality of pressing bodies 510 (FIG. 6) is provided to press both side surfaces of the battery cell. Since the pressing body has a plate shape in which both surfaces thereof are flat, the battery cell may be pressed by both surfaces of the pressing body. The pressing body is configured to be movable in the horizontal direction (x-axis direction: pressing direction). The battery cell is inserted between the pressing bodies, and the pressing bodies may press the battery cell while moving in the horizontal direction. In order to stably press the battery cell, it is preferable for the area of the pressing body to be greater than at least the area of the battery portion in which the electrode assembly of the battery cell is received.

The battery cell support frame 522 may move upward and downward between a first height, which is the height of the battery cell support frame when the battery cell is pressed by the pressing bodies, and a second height, which is the height of the battery cell support frame when receiving the battery cell from the gripper unit.

A lifting shaft housing is coupled to a lower surface of the base frame 521, a lifting shaft movable upward and downward through the base frame 521 from the lifting shaft housing is coupled to the battery cell support frame 522, and the battery cell support frame 521 may be moved upward and downward by upward and downward movement of the lifting shaft. The battery cell support frame 521 and the base frame may be connected to each other via a first guide shaft configured to guide upward and downward movement of the battery cell support frame. A battery cell detection sensor configured to detect the presence or absence of the battery cell may be installed on the battery cell support frame 522.

Guide rails extending in the pressing direction (x) may be installed on both sides of the pressing body 510, and when pressing the battery cell using the pressing body 510, the base frame 521 may move along the guide rails in the pressing direction, whereby the plurality of battery cell support portions 520 may be moved in the pressing direction.

A refrigerant flow path configured to cool the battery cell C may be provided in the pressing body 510. A temperature sensor configured to measure the temperature of the pressing body may be installed in the pressing body 510.

Referring to FIG. 1, the cooling unit 500 may include a first cooling unit 500a configured to press and cool the battery cells in conjunction with the first P&P unit 300a and a second cooling unit 500b configured to press and cool the battery cells in conjunction with the second P&P unit 300b.

FIG. 5 is a plan view of an electrode contact unit of the cooling unit of the battery cell pressing and cooling system according to the embodiment of the present invention.

Referring to FIG. 5, an electrode contact unit 530 configured to measure the voltage of the battery cell when the pressing body presses and cools the battery cell may be formed at each of both ends of the pressing body in the longitudinal direction.

The electrode contact unit 530 may be fixed and formed at a predetermined position on each of both sides of the pressing body.

The electrode contact unit 530, which is fixedly attached to one surface of the pressing body, may include a "^"-shaped lead insertion portion 531 configured to allow a lead 1a (FIG. 4) of the battery cell to be inserted thereinto, a voltage sensing terminal 532 located inside the lead insertion portion 531 in contact with the lead 1a (FIG. 4), and a driving portion 533 configured to move the lead insertion portion 531 forward and backward in a direction in which the lead 1a is located, wherein, when the battery cell is located at a position at which the battery cell is pressed by the pressing body, the driving portion 533 may move the lead insertion portion 531 in the direction toward the lead, whereby the lead 1a may be inserted into the voltage sensing terminal 532 such that the lead 1a and the voltage sensing terminal 532 are in contact with each other.

FIG. 6 is a perspective view of a joint between the lead and the electrode contact unit of the cooling unit of the battery cell pressing and cooling system according to the embodiment of the present invention.

Referring to FIG. 6 together with FIG. 5, the lead insertion portion 531 is formed with a flared front end, and therefore the lead insertion portion may guide a thin lead toward the voltage sensing terminal 532 even if the lead is bent in a specific direction.

During pressing and cooling of the battery cell C, the voltage sensing terminal 532 may collect a profile of the voltage value of the battery cell from the lead 1a and transmit the same to the controller.

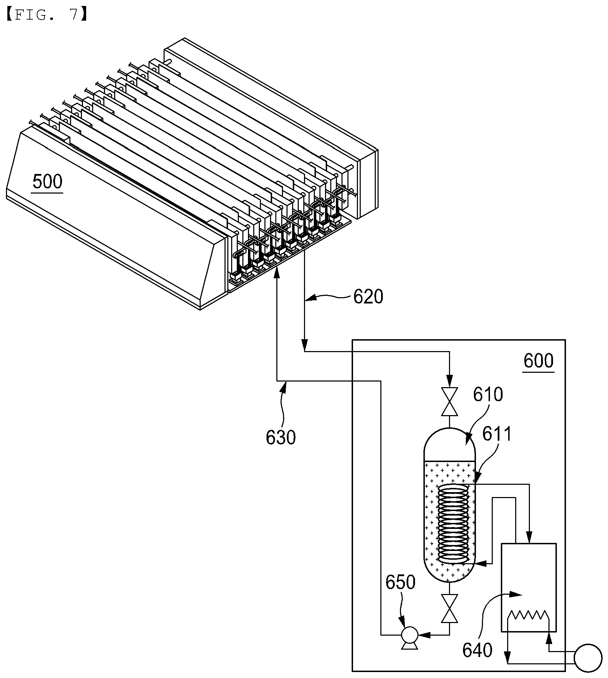

FIG. 7 is a configuration view of a chiller unit of the battery cell pressing and cooling system according to the embodiment of the present invention.

Referring to FIG. 7, a chiller unit 600 configured to supply a refrigerant to the pressing body may be included, and the chiller unit may include a cooling tank 610 configured to receive the refrigerant, wherein the cooling tank 610 is provided with a return port through which the refrigerant, after performing heat exchange with the pressing body of the cooling unit 500, is supplied via a return line 620 and a supply port through which the refrigerant cooled in the cooling tank 610 is discharged via a supply line 630, a refrigerant line 611 configured to perform heat exchange with the refrigerant is formed in the cooling tank 610, and a refrigerator 640 configured to supply cooling energy to the cooling tank 610 via the refrigerant line 611 may be included.

The refrigerator 640 may include a known refrigeration cycle through which the refrigerant circulates so as to be cooled, such as a condenser, a compressor, an evaporator, and an expansion valve, and the refrigerator may cool the refrigerant while the refrigerant circulates in a cycle. A refrigerant line functioning as an evaporator, through which the refrigerant passes while being evaporated so as to be cooled, may be installed in the cooling tank 610, and a heat transfer medium, which is the refrigerant supplied to the cooling unit 500, may be cooled using the principle by which the refrigerant that is evaporated absorbs heat from the heat transfer medium.

A medium circulation pump 650 may be installed in the supply line 630, and the medium circulation pump 650 may circulate the heat transfer medium such that the heat transfer medium is forcibly drawn in through the supply line 630 and is discharged to the cooling unit 500 through the supply line 630, and the heat transfer medium discharged to the cooling unit 500 passes through the cooling channel formed in the pressing body and returns to the cooling tank 610 via the return line 620.

The PPM of the battery cell pressing and cooling system according to the present invention was compared with that of a conventional battery cell pressing and cooling system. The battery cell pressing and cooling system according to the present invention had a processing speed of 20 to 25 PPM, whereas the conventional battery cell pressing and cooling system had a processing speed of 15 PPM.

Those skilled in the art to which the present invention pertains will appreciate that various applications and modifications are possible within the category of the present invention based on the above description.

### (Description of Reference Symbols)

1: Battery portion
1a: Lead
100: Tray
200: Conveyor
210: First conveyor
211: First conversion unit
220: Second conveyor
230: Third conveyor
231: Second conversion unit
300: P&P unit
300a: First P&P unit
300b: Second P&P unit
310: P&P sensor
320: Base plate
330: P&P position adjustment unit
340: P&P discharge unit
400: Gripper unit
400a: First gripper unit
400b: Second gripper unit
410: First support body
420: Second support body
430: Gripper
431: Gripping portion
432: Pressing portion
433: Pressure sensor
500: Cooling unit
500a: First cooling unit
500b: Second cooling unit
510: Pressing body
520: Battery cell support portion
521: Base frame
522: Battery cell support frame
530: Electrode contact unit
531: Lead insertion portion
532: Voltage sensing terminal
533: Driving portion
600: Chiller unit
610: Cooling tank
611: Refrigerant line
620: Return line
630: Supply line
640: Refrigerator
650: Medium circulation pump
C: Battery cell

## Claims

1. A battery cell pressing and cooling system comprising:
a tray configured to receive a plurality of battery cells;
a conveyor configured to transfer the tray;
a pick and place (P&P) unit on the conveyor;
at least one gripper unit configured to move the battery cells; and
at least one cooling unit configured to press and cool the battery cells in the tray, wherein
a transfer line of the conveyor has a " 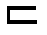 " shape, and the cooling unit is in a " 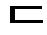 "-shaped inner space of the transfer line.

2. The battery cell pressing and cooling system according to claim 1, wherein
the conveyor comprises:
a first conveyor configured to move the tray in a horizontal (x-axis) direction;
a second conveyor connected orthogonally to the first conveyor, the second conveyor being configured to move the tray in a vertical (y-axis) direction; and
a third conveyor connected orthogonally to the second conveyor, the third conveyor being configured to move the tray in the horizontal (x-axis) direction,
a first conversion unit configured to convert a direction of the tray such that the tray moves to the second conveyor on a first side of the first conveyor in contact with the second conveyor, and
a second conversion unit configured to convert the direction of the tray such that the tray moves to the third conveyor on a first side of the third conveyor in contact with the second conveyor.

3. The battery cell pressing and cooling system according to claim 1, wherein
the P&P unit comprises:
a P&P sensor configured to sense introduction and discharge of the tray;
a base plate on which the tray is located;
a P&P position adjustment unit configured to adjust x-axis and y-axis positions of the tray; and
a P&P discharge unit configured to discharge the tray, and
the P&P position adjustment unit is configured to finely adjust a position of the tray such that the gripper unit grips the battery cells.

4. The battery cell pressing and cooling system according to claim 3, wherein
the gripper unit comprises:
a first support body configured to move in an up-and-down (z-axis) direction;
a second support body configured to move in a horizontal (x-axis) direction and a vertical (y-axis) direction; and
a gripper configured to simultaneously grip the plurality of the battery cells in the tray on the base plate, and
the gripper comprises:
a plurality of " 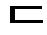 "-shaped gripping portions configured to be in contact with both side surfaces of the respective battery cells;
a pressing portion configured to transmit a driving force to adjust a width of each of the gripping portions such that the gripping portions can grip the battery cells; and
a pressure sensor on an inside of the gripping portion in contact with both side surfaces of each of the battery cells.

5. The battery cell pressing and cooling system according to claim 4, wherein
the cooling unit comprises:
a plurality of pressing bodies facing rectangular planes of the plurality of battery cells, the pressing bodies being configured to press the battery cells; and
a plurality of battery cell support portions configured to move together with the battery cells in a pressing direction when the pressing bodies press the battery cells,
the battery cell support portion comprises:
a base frame under the pressing body; and
a battery cell support frame configured to move the battery cell upward and downward from the base frame in the up-and-down (z-axis) direction, and
a refrigerant flow path (not shown) is in the pressing body.

6. The battery cell pressing and cooling system according to claim 5, wherein an electrode contact unit configured to measure a voltage of the battery cell when the pressing body presses and cools the battery cell is at each of both ends of the pressing body in a longitudinal direction.

7. The battery cell pressing and cooling system according to claim 6, wherein
the electrode contact unit fixedly attached to one surface of the pressing body comprises:
a "^"-shaped lead insertion portion configured to allow a lead of the battery cell to be inserted thereinto;
a voltage sensing terminal inside the lead insertion portion in contact with the lead; and
a driving portion configured to move the lead insertion portion in a direction in which the lead is located or in an opposite direction thereto, and
when the battery cell is at a position at which the battery cell is pressed by the pressing body, the driving portion is configured to move the lead insertion portion in the direction toward the lead such that the lead is in contact with the voltage sensing terminal.

8. The battery cell pressing and cooling system according to claim 7, further comprising:
a chiller unit configured to supply a refrigerant to the pressing body, wherein
the chiller unit comprises a cooling tank configured to receive the refrigerant,
the cooling tank includes a return port through which the refrigerant, after performing heat exchange with the pressing body of the cooling unit, is supplied via a return line and a supply port through which the refrigerant cooled in the cooling tank is discharged via a supply line,
a refrigerant line configured to perform heat exchange with the refrigerant is in the cooling tank, and
the chiller unit comprises a refrigerator configured to supply cooling energy to the cooling tank via the refrigerant line.

9. The battery cell pressing and cooling system according to claim 8, wherein
the P&P unit comprises:
a first P&P unit at the first conveyor; and
a second P&P unit at the third conveyor, and
the first P&P unit and the second P&P unit alternately grip the plurality of battery cells in the plurality of trays that are sequentially introduced.

10. The battery cell pressing and cooling system according to claim 9, wherein
the gripper unit is configured to grip the plurality of the battery cells and position the gripped battery cells between the plurality of pressing bodies, and
upon completion of pressing and cooling of the battery cells, the gripper unit is configured to grip the battery cells again and move the gripped battery cells to the tray.

11. The battery cell pressing and cooling system according to claim 10, wherein the cooling unit comprises:
a first cooling unit configured to press and cool the battery cells in conjunction with the first P&P unit; and
a second cooling unit configured to press and cool the battery cells in conjunction with the second P&P unit.

12. The battery cell pressing and cooling system according to claim 11, wherein the gripper unit comprises:
a first gripper unit configured to grip the battery cells in conjunction with the first P&P unit; and
a second gripper unit configured to grip the battery cells in conjunction with the second P&P unit.

13. A method of controlling a battery cell pressing and cooling system, the method comprising:
a first step of sequentially introducing a plurality of trays, each of the plurality of trays being configured to receive a plurality of battery cells, to a conveyor;
a second step of moving the tray to a predetermined position through a P&P unit on the conveyor;
a third step of moving the plurality of battery cells from the tray to a cooling unit through a gripper unit;
a fourth step of simultaneously pressing and cooling the plurality of battery cells through the cooling unit;
a fifth step of moving the plurality of battery cells, after completion of the pressing and the cooling, to the tray through the gripper unit; and
a sixth step of sequentially discharging the plurality of trays, each having the plurality of battery cells received therein, from the conveyor, wherein
a transfer line of the conveyor has a " 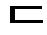 " shape,
the cooling unit is in a " 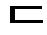 "-shaped inner space of the transfer line, and
each of the P&P unit, the gripper unit, and the cooling unit is one or more P&P unit, gripper unit or cooling unit, respectively.
